(19) Europäisches Patentamt
European Patent Office
Office européen des brevets

(11) **EP 2 113 948 B1**

(12) **EUROPEAN PATENT SPECIFICATION**

(45) Date of publication and mention
of the grant of the patent:
**02.01.2019  Bulletin 2019/01**

(51) Int Cl.:
***H01L 31/05*** *(2014.01)*      ***H01L 31/0224*** *(2006.01)*

(21) Application number: **09251167.4**

(22) Date of filing: **23.04.2009**

(54) **Solar cell module**

Solarzellenmodul

Module de cellule solaire

(84) Designated Contracting States:
**AT BE BG CH CY CZ DE DK EE ES FI FR GB GR
HR HU IE IS IT LI LT LU LV MC MK MT NL NO PL
PT RO SE SI SK TR**

(30) Priority:   **28.04.2008   JP 2008117897**

(43) Date of publication of application:
**04.11.2009   Bulletin 2009/45**

(73) Proprietor: **Panasonic Intellectual Property
Management Co., Ltd.
Osaka-shi, Osaka 540-6207 (JP)**

(72) Inventor: **Taira, Shigeharu
Moriguchi City,
Osaka 570-8677 (JP)**

(74) Representative: **Addiss, John William et al
Mewburn Ellis LLP
City Tower
40 Basinghall Street
London EC2V 5DE (GB)**

(56) References cited:
**EP-A1- 1 939 944      WO-A1-2008/023795
JP-A- 2004 031 740    JP-A- 2005 016 906
US-A- 5 009 243**

## Description

The present invention relates to a solar cell module having a plurality of solar cells electrically connected to one another by wiring members.

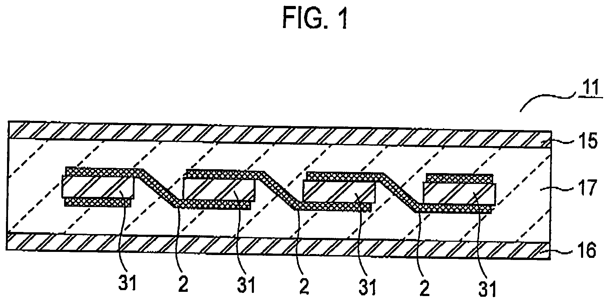

As shown in a schematic cross-sectional view in Fig. 1, a solar cell module 11 is configured in such a manner that a plurality of solar cells 31 which are electrically connected to one another by wiring members 2 are sealed with a sealing member 17 between a light-receiving surface protection member 15 and a back surface protection member 16.

Each solar cell 31 includes a photoelectric conversion part having a photoelectric conversion function and a collecting electrode provided on the light-receiving surface of the photoelectric conversion part. The collecting electrode includes: a plurality of line-shaped thin line-shaped electrodes provided so as to be parallel to one another over substantially the entire region of the light-entering surface of the photoelectric conversion part; and a connecting electrode provided so as to extend in a direction perpendicular to the longitudinal direction of the thin line-shaped electrode. The wiring member 2 is bonded on the connecting electrode by solder so that the adjacent multiple solar cells 31 are electrically connected to one another (see, for example, Japanese Patent Application Publication No. 2002-359388).

In addition, it has been considered that a resin-bonding member containing conductive particles is used in place of solder as a bonding material to bond a wiring member 2 to solar cells 31 to lower a temperature at the time of bonding the wiring member 2 (see, for example, Japanese Patent Application Publication No. 2005-101519). The lowering of the temperature at the time of bonding the wiring member as described above can suppress occurrence of warpage, cracking, or chipping attributable to a difference of the thermal expansion coefficient between the wiring member and the solar cell.

Meanwhile, in such a connection method using the resin-bonding member, the wiring member and the connecting electrode are electrically connected to each other only through the conductive particles. Accordingly, it is predicted that the electric resistance between the wiring member and the connecting electrode becomes larger than those in the case where the connection is performed by using solder. For this reason, the applicant of the present invention has filed a method for alleviating such a problem (see, for example, International Patent Application Publication No. 2008/023795 Pamphlet). This connection method is briefly described below by referring to the drawings.

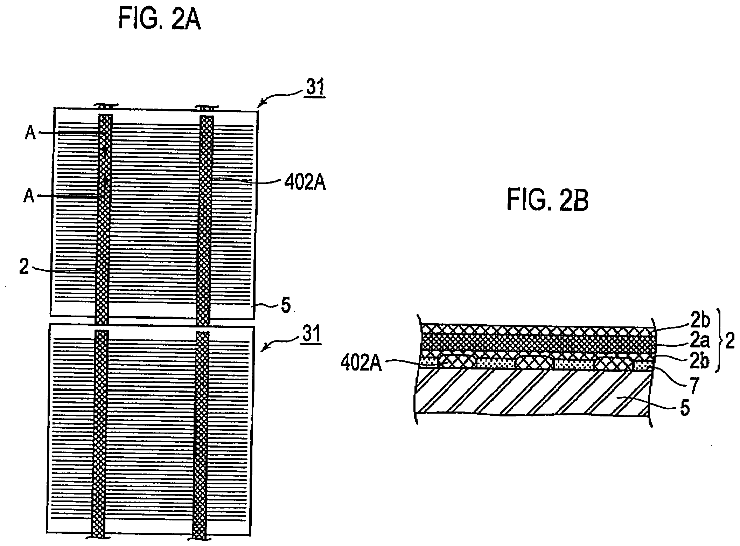

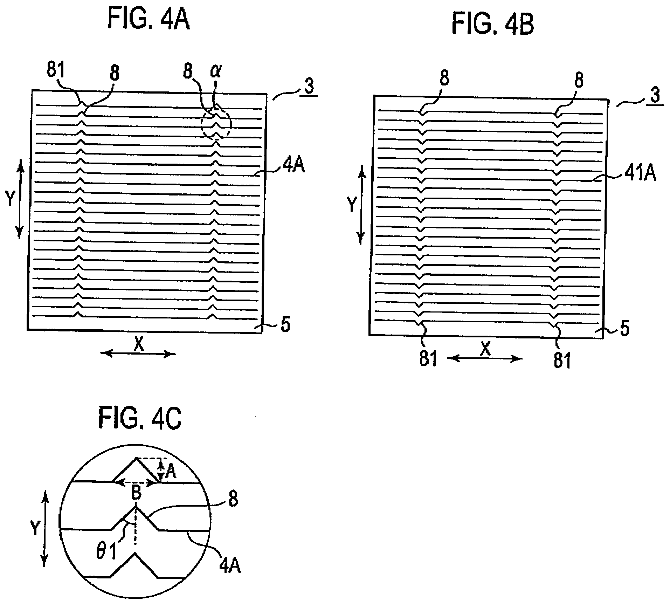

Fig. 2A is a plane view of a solar cell 31 in which a wiring member 2 is connected thereon by this method, as seen from the light-receiving surface side. Fig. 2B is an enlarged cross-sectional view taken along the A-A line in Fig. 2A. As shown in Fig. 2A, thin line-shaped electrodes 402A are formed so as to be substantially parallel to one another over substantially the entire region of the photoelectric conversion part 5 and a connecting electrode is not formed thereon. The wiring member 2 includes a core member 2a made of a metal such as copper and a conductive layer 2b such as solder formed on the surface of the core member 2a. In addition, as shown in Fig. 4B, the tip end of each thin line-shaped electrode 402A comes into the conductive layer 2b, so that the wiring member 2 and the thin line-shaped electrode 402A are electrically connected to each other. In addition, the solar cell 31 and the wiring member 2 are mechanically connected to each other by a resin-bonding member 7.

In this method, the resin-bonding member 7 is used to mechanically connect the wiring member 2 and the solar cell 31. Accordingly, as compared with the connection made through solder, a temperature at the time of bonding the wiring member 2 and the solar cell 31 can be reduced. For this reason, the warpage of the solar cell 31 due to heat to be applied at the time of the bonding can be reduced. In addition, the electrical connection between the solar cell 31 and the wiring member 2 is made in such a manner that the thin line-shaped electrode 402A comes into the conductive layer 2b of the wiring member 2. Accordingly, an electric resistance can be reduced as compared with the connection made through a conductive material such as solder. Moreover, there is no need to provide a connecting electrode, so that the cost of manufacturing a solar cell module can be reduced.

However, in the above-described method, the lateral direction of the thin line-shaped electrodes 402A agrees with the longitudinal direction of the wiring member 2. Accordingly, the thermal expansion and contraction to be generated in the longitudinal direction of the wiring member 2 are received by the thin line-shaped electrodes 402A in the lateral direction. As a result, it is anticipated that stress is applied to the thin-shaped electrodes 402A.

US-A-5009243 discloses a solar harness with a plurality of solar cells interconnected by wiring members. One surface of each solar cells has a plurality of thin line-shaped electrodes thereon, connected to the wiring members. The thin line-shaped electrodes form a series of chevrons across the surface of the solar cells.

Against this background, the present invention aims to provide a solar cell module which suppresses stress to be applied to a thin line-shaped electrode and may thereby be improved in its reliability. The present invention provides a solar cell module according to claim 1.

According to the aspect of the invention, the protruding part toward the second thin line-shaped electrode is formed in the connection region. With this configuration, the stress to be applied to the first thin line-shaped electrode is dispersed due to the inclination of the protruding part. Accordingly, as compared with the case where stress is directly applied to the first thin line-shaped electrode, the stress to be applied to an interface between the wiring member and the first thin line-shaped electrode can be reduced. This suppresses deterioration of the bonding strength in the interface between the wiring member and the first thin line-shaped electrode, so that reliability of the solar cell module can be increased.

The solar cell module according to the present invention may optionally be as specified in any one of claims 2 to 7.

In the drawings:

Fig. 1 is a cross-sectional view showing a solar cell module according to a conventional art; and

Figs. 2A and 2B are views, each illustrating a connection relationship between a solar cell and a wiring member of the solar cell module according to the conventional art;

Fig. 3 is a cross-sectional view showing a solar cell module according to a first embodiment of the present invention;

Figs. 4A to 4C are plane views, each showing the solar cell module according to the first embodiment;

Figs. 5A and 5B are plane views, each illustrating a connection relationship between a solar cell and a wiring member of the solar cell module according to the first embodiment;

Fig. 6 is a cross-sectional view for illustrating the connection relationship between the solar cell and the wiring member of the solar cell module according to the first embodiment;

Figs. 7A to 7F are plane views respectively illustrating thin line-shaped electrodes according to a modification;

Figs. 8A to 8C are plane views, each showing a solar cell according to a second embodiment;

Figs. 9A and 9B are plane views, each illustrating a connection relationship between a solar cell and a wiring member of a solar cell module according to the second embodiment.

Preferred embodiments of the present invention are described below by referring to the drawings. In the following description of the drawings, the same or similar parts are denoted by the same or similar reference numerals. However, it should be noted that the drawings are merely schematically shown and sizes and proportions are different from actual ones. Thus, specific sizes and the like should be judged by referring to the description below. In addition, it goes without saying that there are included portions where relationships or proportions of sizes of the drawings are different with respect to one another.

«First Embodiment»

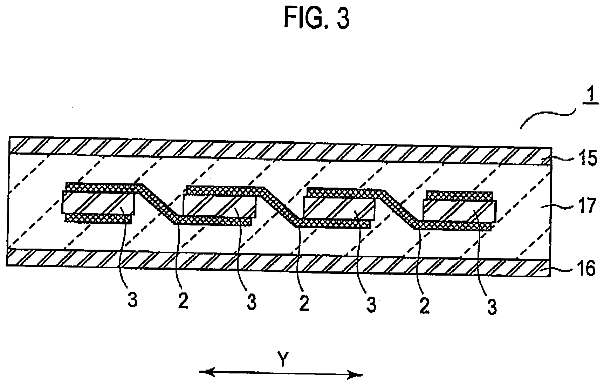

Firstly, a solar cell module 1 according to a first embodiment is described by referring to Figs. 3 to 6.

(Configuration of Solar Cell Module)

Fig. 3 is a conceptual cross-sectional view showing a configuration of the solar cell module 1 according to the present embodiment. The solar cell module 1 includes a plurality of solar cells 3 which is arranged along the arrangement direction Y, a wiring member 2, a light-receiving surface protection member 15, a sealing member 17, and a back surface protection member 16. The adjacent solar cells 3 are electrically connected to each other by the wiring member 2 which extends along the arrangement direction Y.

The translucent light-receiving surface protection member 15 is bonded on the light-receiving surface side of the plurality of solar cells 3 with the translucent sealing member 17. The light-receiving surface protection member 15 is formed of a translucent material such as a glass or translucent plastic, for example. In addition, the back surface protection member 16 is bonded on the back surface side of solar cells 3 with the sealing member 17. The back surface protection member 16 is formed of, for example, a resin film such as PET, or a laminated film having a structure in which Al foil is sandwiched between resin films.

The sealing member 17 is, for example, a translucent resin such as EVA or PVB and has a function to seal the plurality of solar cells 3. Furthermore, a terminal box (unillustrated) for extracting electric power is arranged on, for example, the back surface of the back surface protection member 16. Additionally, a frame body is attached to an outer periphery of the solar cell module, as needed.

When the solar cell module 1 in this structure is manufactured, a laminated body is firstly manufactured by sequentially laminating the light-receiving surface protection member 15, the sealing member 17, the plurality of solar cells 3, the sealing member 17, and the back surface protection member 16. Subsequently, pressure is applied from upper and lower sides of the laminated body to heat the laminated body. In this manner, the solar cell module 1 is manufactured.

(Configuration of Solar Cell)

Fig. 4A is a plane view seen from the light-receiving surface side of the solar cell 3 according to the present embodiment. Fig. 4B is a plane view seen from the back surface side of the solar cell 3. Fig. 4C is an enlarged view of an essential part of an encircled region $\alpha$ in Fig. 4A. As shown in Figs. 4 (a) and 4 (b), the solar cell 3 includes a photoelectric conversion part 5 and a collecting electrode which are provided on each of the light-receiving surface and back surface of the photoelectric conversion part 5. The photoelectric conversion part 5 generates photogenerated carriers thereinside by receiving light. The photogenerated carriers are electrons and holes, which are generated in the photoelectric conversion part 5 by receiving light.

The photoelectric conversion part 5 is made of a semiconductor material having a semiconductor junction such as a pn junction or a pin junction. As the semiconductor material, there can be used a semiconductor material made of, for example, a crystalline silicon semiconductor such as a single crystal semiconductor silicon or a polycrystal silicon, a compound semiconductor such as GaAs, an amorphous silicon-based thin film semiconductor, a compound-based thin film semiconductor, and other well-known semiconductor materials. Additionally, as a material for forming a semiconductor junction between the above-described semiconductor materials, a crystalline semiconductor, an amorphous semiconductor, a compound semiconductor, or other well-known semiconductor materials can be used.

As shown in the plane view in Fig. 4A, the collecting electrode formed on the light-receiving surface of the photoelectric conversion part 5 includes a plurality of thin line-shaped electrodes 4A each having a thin wire shape. The plurality of thin line-shaped electrodes 4A are arranged along an arrangement direction Y in such a manner that the arrangement direction Y of the plurality of solar cells 3 is set as the lateral direction and the direction X substantially perpendicular to the arrangement direction Y is set as the longitudinal direction. One portion of each of the thin line-shaped electrodes 4A functions as a connecting electrode for connection with the wiring member 2, as is to be described later. The thin line-shaped electrodes 4A are electrodes configured to collect carriers of electrons and holes which are generated by the photoelectric conversion part 5 by receiving light. The thin line-shaped electrodes 4A are arranged so as to be parallel to one another over substantially the entire region of the light-receiving surface of the photoelectric conversion part 5. Note that the size and number of the thin line-shaped electrodes 4A are set as appropriate by taking into consideration the size, properties and the like of the photoelectric conversion part 5.

As shown in Fig. 4A, each thin line-shaped electrode 4A has a protruding part 8 protruding toward an adjacent thin line-shaped electrode 4A, in a region to which the wiring member 2 is connected. In Fig. 4A, the protruding part 8 has a mountain-like shape. At this time, as shown in Fig. 4C, the protruding part 8 is formed in such a manner as to have an angle θ with respect to the arrangement direction Y and protrude toward the arrangement direction Y with a height A and a width B. Additionally, the protruding part 8 is formed in a portion functioning as a connecting electrode for connecting the wiring member 2.

Fig. 4B is a plane view seen from the back surface side of the solar cell 3. Similar to the collecting electrode formed on the light-receiving surface side, a collecting electrode formed on the back surface also includes a plurality of thin line-shaped electrodes 41A. As shown in Fig. 4B, the thin line-shaped electrodes 41A are arranged along the arrangement direction Y so that the arrangement direction Y of the plurality of solar cells 3 is defined as the lateral direction and the direction X substantially perpendicular to the arrangement direction Y is defined as the longitudinal direction. The thin line-shaped electrodes 41A are electrodes for collecting carriers of electrodes and holes which are generated by the photoelectric conversion part 5 by receiving light. The thin line-shaped electrodes 41A are arranged so as to be parallel to one another over substantially the entire region of the back surface of the photoelectric conversion part 5. One portion of the thin line-shaped electrode 41A also functions as a connecting electrode for connecting the wiring member 2.

As shown in Fig. 4B, each thin line-shaped electrode 41A has a protruding part 8 protruding toward an adjacent thin line-shaped electrode 41A, in a region to which the wiring member 2 is connected. The size and number of the thin line-shaped electrodes 41A on the back surface side are set as appropriate by taking into consideration the size, properties and the like of the photoelectric conversion part 5. The collecting electrode 41 on the back surface side is not limited to the above-described configuration and can have various kinds of configurations. For example, a conductive member may be formed on the entire back surface to be used as a collecting electrode.

Note that, among the protruding parts 8 formed on the light-receiving surface and the back surface, a protruding part 81 on which an end portion of the wiring member 2 is arranged is preferably formed small so as not to protrude from the end of the wiring member 2. In the present embodiment, the direction of the protruding parts 8 formed on each of the light-receiving surface and the back surface are formed so as to be opposite to each other when projected from the light-receiving surface. However, the protruding parts 8 may be formed so as to have the same direction. In the present embodiment, each of the protruding parts 8 is formed in the same direction. However, the protruding part 8 may be formed so as to have a different direction from each other. In the present embodiment, the protruding part 8 is formed in each of the regions of the plurality of thin line-shaped electrodes 4A and 41A, which correspond to wiring members 2. However, the protruding part 8 may be formed in only some of the regions thereof. In addition, on the thin line-shaped electrodes 4A and 41A which are provided in an outermost portion in the arrangement direction of the thin line-shaped electrodes 4A and 41A, the height A of the protruding part 8 may be set small so as not to protrude from the wiring member 2, or formation of the protruding part 8 is not necessarily required. Additionally, the width B of the protruding part preferably has a size with which the protruding part does not protrude from the wiring member 2.

The thin line-shaped electrodes 4A and 41A are formed of, for example, a thermosetting conductive paste using an epoxy resin as a binder and conductive particles as a filler. In the case of a single crystal silicon solar cell, a polycrystal silicon solar cell, or the like, it is not limited to this conductive paste, and a baking type paste may also be used. The baking-type paste is formed of metal powder such as silver or aluminum, a glass flit, an organic vehicle, and the like. It may also be formed of a general metal material such as silver or aluminum.

(Connection of Wiring Member)

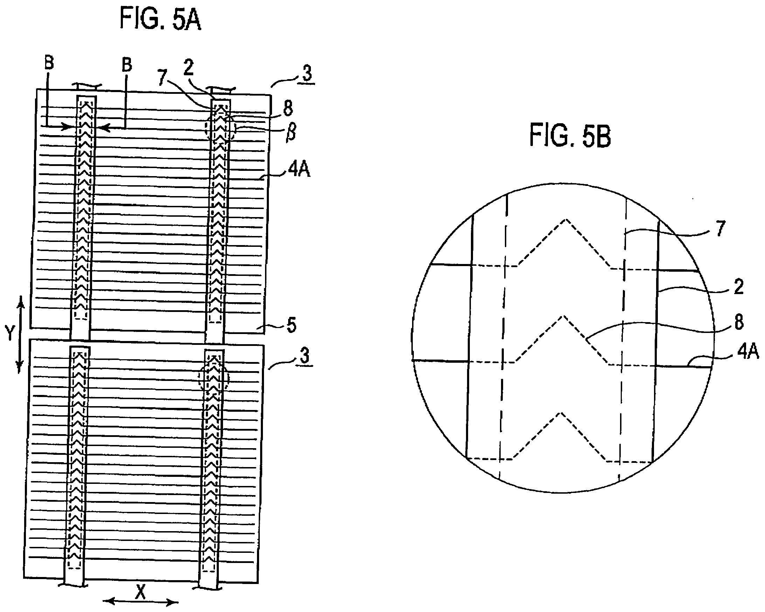

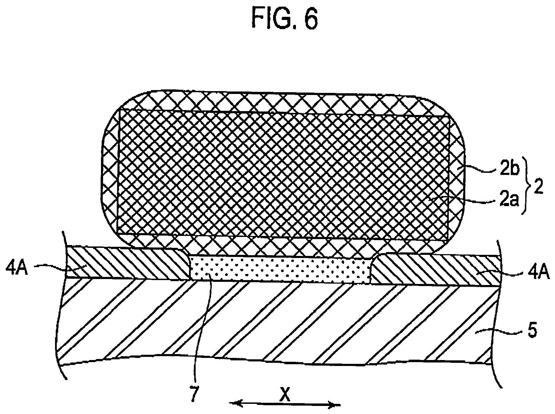

Fig. 5A is a plane view seen from the light-receiving surface side of the solar cell for illustrating a connection relationship between the wiring member 2 and the thin line-shaped electrodes 4A. Fig. 5B is an enlarged view of an encircled region β shown in Fig. 5A. Fig. 6 is an enlarged cross-sectional view taken along the B-B line shown in Fig. 5A.

As shown in Figs. 5A and 5B, the wiring member 2 is arranged on the protruding parts 8 along the arrangement direction Y of the plurality of solar cells 3. The protruding parts 8 protrude along the arrangement direction Y.

As shown in Fig. 6, the wiring member 2 is configured of a core member 2a such as copper and a conductor layer 2b which is formed of solder or the like and is formed on the surface of the wiring member 2. The thin line-shaped electrode 4A and the protruding part 8 come into the conductor layer 2b of the wiring member 2, so that the wiring member 2 and the thin line-shaped electrode 4A are electrically connected to each other. Additionally, the wiring member 2 and the solar cell 3 are mechanically connected with a resin-bonding member 7. As shown in Fig. 5B, the wiring member 2 and the solar cell 3 are bonded to each other so that the peripheries of the protruding parts 8 would also be coved with the resin-bonding member 7. As shown in Fig. 5B, the resin-bonding member 7 may be divided by the adjacent thin line-shaped electrodes.

The material of the resin-bonding member 7 includes, for example, an epoxy resin, acrylic resin, polyimide resin, phenol resin, urethane resin, silicon resin and the like, and at least one kind of resins selected from the foregoing resins or a mixture, copolymer or the like of these resins may be used as the material of the resin-bonding member 7. The resin-bonding member 7 may have conductivity by adding metal particles selected from the group consisting of nickel, copper, silver, aluminum, tin, gold and the like, or may have an insulating property. In the case of the conductive resin-bonding member 7, the wiring member 2 and the solar cell 3 may be electrically connected through conductive particles.

(Operations and Effects)

In the solar cell module 1 according to the present embodiment, each of the thin line-shaped electrodes 4A and 41A has the protruding part 8 which protrudes toward each of the adjacent thin line-shaped electrodes 4A and 41A, and the wiring member 2 is arranged on the protruding part 8. The wiring member 2 is connected on the protruding part 8. At this time, the longitudinal direction of the wiring member 2 becomes a direction being along to the arrangement direction Y, and thus becomes the same direction as the protruding direction of the protruding part 8.

The wiring member 2 expands and contracts due to heat even after the wiring member 2 and the plurality of solar cells 3 are bonded. At this time, the wiring member 2 largely expands and contracts in the longitudinal direction of the wiring member 2 rather than the lateral direction thereof. In such a case, the force generated by the expansion and contraction of the wiring member 2 in the longitudinal direction (arrangement direction Y) is conventionally applied to a connection interface between the wiring member 2 and each of the thin line-shaped electrodes 4A and 41A, in a direction perpendicular to the lateral direction of the thin line-shaped electrodes 4A and 41A. Accordingly, the force in the longitudinal direction (arrangement direction Y) of the wiring member 2 is applied to the connection parts between the wiring member 2 and each of the thin line-shaped electrodes 4A and 41A while maintaining the power of the force. Thus, stress is concentrated on the interface of each of the connection parts.

Against this background, in the present embodiment, the protruding part B protruding in the longitudinal direction (arrangement direction Y) of the wiring member 2 is formed in the region to which the wiring member 2 is connected. At this time, each protruding part 8 is provided so as to have an angle $\theta 1$ with respect to the force to be applied in the longitudinal direction (arrangement direction Y) of the wiring member 2. Accordingly, the force to be applied to each of the thin line-shaped electrodes 4A and 41A in the arrangement direction Y is dispersed into force in a direction parallel to the inclination of the mountain-like shape of the protruding part 8 and force in a direction perpendicular to the inclination. At this time, the force to be applied to each of the thin line-shaped electrodes 4A and 41A is the force perpendicular to the inclination of the protruding part. Accordingly, in comparison with the case where the stress in the longitudinal direction (arrangement direction Y) of the wiring member 2 is directly applied to each of the thin line-shaped electrodes 4A and 41A, the protruding part 8 is capable of reducing the stress to be applied to the interface between the wiring member 2 and each of the thin line-shaped electrodes 4A and 41A. Thus, the bonding strength between the wiring member 2 and each of the thin line-shaped electrodes 4A and 41A can be prevented from being deteriorated, and the reliability of the solar cell module 1 can be increased.

The wiring member 2 and the solar cell 3 are mechanically connected by use of the resin-bonding member 7, and the periphery of the protruding part 8 is also bonded to the wiring member 2 so as be covered with the resin-bonding member 7. Accordingly, the area of bonding between 41A and the resin-bonding member 7 and each of the thin line-shaped electrodes 4A can be increased. Thus, the deterioration of the bonding strength is suppressed, so that the reliability of the solar cell module 1 can be increased.

The wiring member 2 is connected on the protruding part 8, and therefore, the area of the bonding of the wiring member 2 can be increased in comparison with the case where there is no protruding part 8 . Accordingly, the bonding strength of the wiring member 2 and the solar cell 3 can be increased, so that the reliability of the solar cell module 1 can be increased.

In the present embodiment, each of the protruding parts 8 provided on each of the light-receiving surface and the back surface is formed so as to have the same direction within the same plane. However, each of the protruding parts 8 may be formed so as to have different directions in the same plane. Even in such a case, the stress generated by the expansion and contraction of the wiring member 2 can be reduced.

In the present embodiment, the resin-bonding member 7 is divided by the protruding part 8. For this reason, the stress generated by the expansion and contraction of the resin-bonding member 7 can be reduced.

In the present embodiment, each of the thin line-shaped electrodes 4A and the wiring member 2 come into the conductive layer 2b of the wiring member 2 so as to be electrically connected to each other. Thus, in comparison with the electrical connection through a conductive adhesive or the like, an electric resistance can be reduced. Consequently, the characteristics of the solar cell module can be improved.

(Modification)

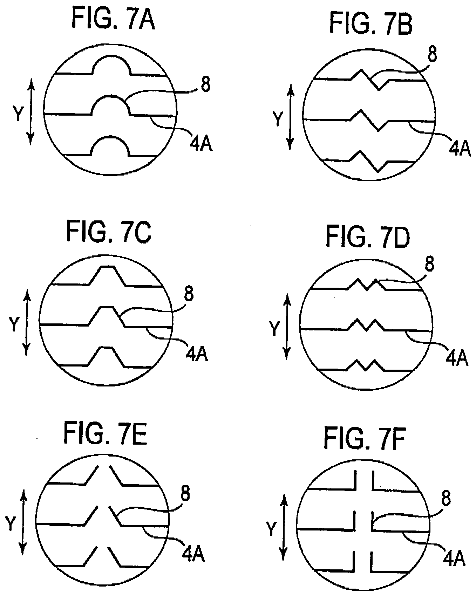

In the present embodiment, each protruding part 8 is formed in a mountain-like shape. However, the shape of the protruding part 8 is not limited to this and can take various forms, such as an arc form and a trapezoidal form as shown in the enlarged plane views of Figs. 7A to 7F respectively showing the shapes of protruding parts 8. As shown in Fig. 7E, it is not necessary that the top portions of the protruding part 8 are continuous. Even in such a case, the formation of the protruding part 8 as shown in Fig. 7E in the region to which the wiring member 2 is connected can reduce the stress generated due to the expansion and contraction of the wiring member 2 and the solar cell 3, similar to the first embodiment. Thus, the reliability of the solar cell module 1 can be increased.

«Second Embodiment»

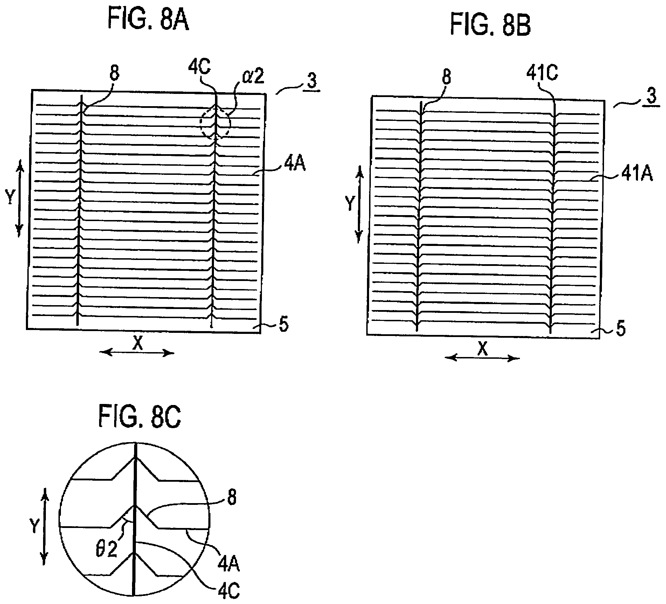

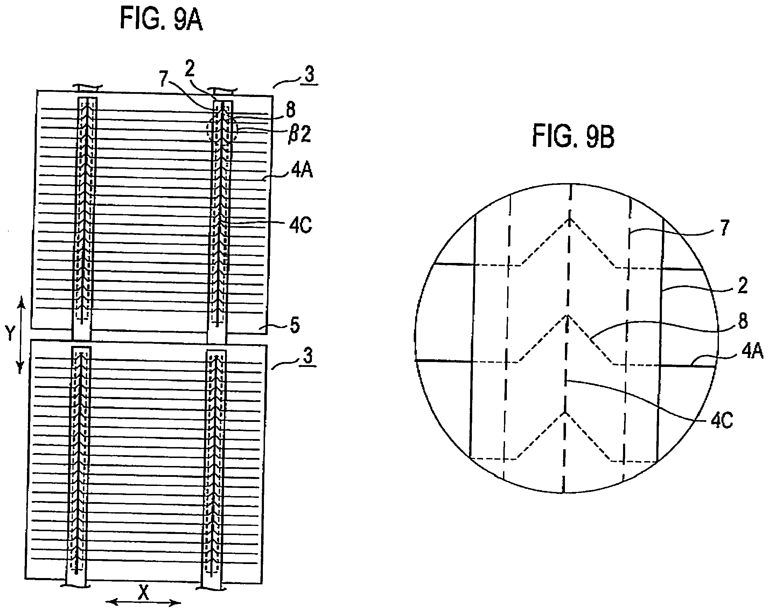

A second embodiment of the present invention is described below by referring to Figs. 8 and 9. In the following description, description of portions same as or similar to those of the first embodiment will be omitted.

The second embodiment is different from the first embodiment in that an auxiliary electrode 4C is provided.

(Solar Cell)

Figs. 8A and 8B are plane views which are respectively seen from the light-receiving surface side and back surface side of a solar cell 3 according to the second embodiment. Fig. 8C is an enlarged view of a portion which is an encircled region $\alpha 2$ shown in Fig. 8A.

As shown in Figs. 8A and 8B, thin line-shaped electrodes 4A and protruding parts 8 similar to the first embodiment and the auxiliary electrodes 4C are formed on the light-receiving surface of the solar cell 3, while thin line-shaped electrodes 41A and protruding parts 8 similar to the first embodiment and the auxiliary electrodes 41C are formed on the back surface of the solar cell 3. The plurality of thin line-shaped electrodes 4A and 41A are arranged along the arrangement direction Y in such a manner the arrangement direction Y of the solar cell 3 is set as the lateral direction and the direction X substantially perpendicular to the arrangement direction Y is set as the longitudinal direction. As shown in Figs. 8A and 8B, the auxiliary electrodes 4C and 41C are formed so as to extend along the arrangement direction Y of the solar cell 3 to connect top portions of the protruding parts 8, so that the auxiliary electrodes 4C and 41C are electrically connected to the thin line-shaped electrodes 4A and 41A, respectively. The width of each of the auxiliary electrodes 4C and 41C is formed so as to be equal to or about ten times the width of each of the thin line-shaped electrodes 4A and 41A. The auxiliary electrodes 4C and 41C respectively function as bus bar electrodes configured to collect carriers collected by the thin line-shaped electrodes 4A and 41A and also function as connecting electrodes to which the wiring member 2 is connected.

As shown in Fig. 8C, similar to the first embodiment, each protruding part 8 is formed so as to have an angle $\theta 2$ with respect to the arrangement direction Y.

(Connection of Wiring Member)

Fig. 9A is a plane view seen from the light-receiving surface side of the plurality of solar cells 3 for illustrating a connection relationship between the wiring members 2 and the thin line-shaped electrodes 4A. Fig. 9B is an enlarged view of an encircled region β2 shown in Fig. 9A.

As shown in Figs. 9A and 9B, the wiring member 2 is arranged on the protruding parts 8 along the arrangement direction Y of the plurality of solar cells 3. Each of the protruding parts 8 protrudes in a direction along the arrangement direction Y.

As shown in Figs. 9A and 9B, each of the wiring members 2 is arranged on the corresponding auxiliary electrode 4C, and is arranged so as to extend in such a manner that the longitudinal direction thereof is parallel to the arrangement direction Y of the solar cell 3. Such arrangement of the wiring member 2 matches the longitudinal direction of the wiring member 2 with the longitudinal direction of the auxiliary electrode 4C.

Additionally, as shown in Fig. 9B, the wiring member 2 and the solar cell 3 are mechanically connected to each other with a resin-bonding member 7. At least either the thin line-shaped electrode 4A or the auxiliary electrode 4C and the protruding part 8 comes into a conductive layer 2b of the wiring member 2, and thereby electrical connection is achieved. As shown in Fig. 9B, the peripheries of the protruding part 8 and the auxiliary electrode 4C are also covered and bonded with the resin-bonding member 7.

(Operations and Effects)

In the present embodiment, effects similar to those of the first embodiment can also be exhibited.

In the present embodiment, the wiring member 2 is also connected on the protruding parts 8 and the auxiliary electrodes 4C and 41C. Thus, the bonding strength can be increased.

In addition, the auxiliary electrodes 4C and 41C are formed extending along the arrangement direction Y so as to connect top portions of the protruding parts 8. In addition, the wiring member 2 is also connected to each of the auxiliary electrodes 4C and 41C. Thus, the connection between the wiring member 2 and each of the thin line-shaped electrodes 4A and 41A can be ensured, so that the reliability of the solar cell module can be improved.

The auxiliary electrodes 4C and 41C are formed so as to have same as or ten times the width of each of the thin line-shaped electrodes 4A and 41A. Accordingly, it is suppressed that the auxiliary electrodes 4C and 41C protrude due to misalignment or the like at the time of wiring.

(Examples)

The solar cell module according to the present invention is specifically described below by using examples.

As an example of the present invention, the solar cell module according to the first embodiment is manufactured as described below. The manufacturing method is described below by dividing steps into steps 1 to 5.

<Step 1>

Photoelectric conversion part Formation

Firstly, prepared was an n-type single crystal silicon substrate of an approximately-125-cm square with the resistivity of approximately 1 $\Omega$/cm and the thickness of approximately 200 $\mu$m. Subsequently, an i-type amorphous silicon layer with the thickness of approximately 5 nm and a p-type amorphous silicon layer with the thickness of approximately 5 nm were formed in this order on a light-receiving surface of the n-type single crystal silicon substrate, by using the CVD method.

Thereafter, an i-type amorphous silicon layer with the thickness of approximately 5 nm and an n-type amorphous silicon layer with the thickness of approximately 5 nm were formed in this order on a back surface of the n-type single crystal silicon substrate, by using the CVD method.

After that, an ITO film with the thickness of approximately 100 nm was formed on each of the p-type amorphous silicon layer and the n-type amorphous silicon layer, by using the sputtering method.

With the steps described above, a photoelectric conversion part of a solar cell according to the example was manufactured.

<Step 2>

Collecting electrode Formation

Next, a collecting electrode having the following shape was formed on the surface of the ITO film disposed on each of the light-receiving surface side and back surface side of the photoelectric conversion part by the screen printing method using an epoxy-based thermosetting silver paste.

For each of the samples of Examples 1 to 5 according to the first embodiment, the plurality of thin line-shaped electrodes 4A and 41A each having a width of approximately 100 $\mu$m and a thickness of approximately 40 $\mu$m were formed at a pitch of approximately 2 mm. In addition, the protruding parts 8 were each formed so as to have a width of 2 mm, and the angles $\theta 1$ of the protruding parts 8 with respect to the arrangement direction Y were set at 15°, 30°, 45°, 60°, and 75°, for the samples of Examples 1 to 5, respectively.

<Step 3>

Wiring Member Connection

Next, a resin-bonding member containing a thermosetting epoxy-based resin was applied using a dispenser or the like onto predetermined portions near the protruding parts 8 on the light-receiving surface side and back surface side of the samples of Examples 1 to 5. Subsequently, a wiring member with a core member made of copper covered with a conductive layer made of solder was arranged on the resin-bonding member applied to each of the samples.

Thereafter, the wiring member 2 disposed on the solar cell was sequentially sandwiched from upper and lower sides between heaters and then heated while a predetermined pressure is applied thereto, so that the solar cell 3 and the wiring member 2 were connected to each other. In addition, the pressure was adjusted so that the projection of the connecting electrode would come into the conductive layer formed on the surface of the wiring member 2, depending on the corresponding sample in Examples 1 to 5. The pressures have been obtained in advance by a preliminary experiment.

(Comparative Example)

A sample of Comparative Example 1 was manufactured by a method similar to that for the samples of Examples 1 to 5, except that protruding parts were not formed.

(Results)

Regarding the solar cell modules according to Examples 1 to 5 and Comparative Example 1, a temperature cycle test (JIS C8917) was carried out for a period which was three times longer than usual. After that, the degradation ratio of output of the solar cell module, which was observed by the temperature cycle test, was calculated from the conversion efficiency before the test and the conversion efficiency after the test as shown in Formula 1.

[ Formula 1]

$$\text{degradation ratio}(\%) = \frac{\text{conversion efficiency before test} - \text{conversion efficiency after test}}{\text{conversion efficiency before test}} \times 100$$

Table 1 shows the results of the solar cell modules according to Examples 1 to 5 and Comparative Example 1.

[Table 1]

|  | Angle $\theta 1$ | Degradation ratio[%] |
|---|---|---|
| Comparative example 1 | - | 4.9 |
| Example 1 | 15° | 4.8 |
| Example 2 | 30° | 4.8 |
| Example 3 | 45° | 4.5 |
| Example 4 | 60° | 4.3 |
| Example 5 | 75° | 4.2 |

As can be seen from Table 1, the degradation ratios of Examples 1 to 5 were improved in relation to that of Comparative Example 1. In addition, these results probably show that the stress to be applied in the arrangement direction Y of the solar cell due to the thermal expansion and contraction of the wiring member was reduced, because the samples of Examples 1 to 5 had protruding parts each formed so as to have the angle $\theta 1$ with respect to the arrangement direction Y of the solar cell in the region on the thin line-shaped electrode to which the wiring member was connected. Accordingly, it is understood that the deterioration of the bonding strength in the interface between the wiring member and the thin line-shaped electrodes was suppressed and thus the degradation ratio of the solar cell module was improved.

## Claims

1. A solar cell module, comprising:

   a plurality of solar cells (3) arranged along an arrangement direction (Y); and
   a wiring member (2) configured to electronically connect the plurality of solar cells (3) to each other, wherein each of the plurality of solar cells (3) includes a surface, and a plurality of thin line-shaped electrodes (4A) which are arranged on the surface along the arrangement direction (Y),
   the wiring member (2) is electrically connected to the thin line-shaped electrodes (4A), and
   a first thin line-shaped electrode (4A) of the plurality of thin line-shaped electrodes (4A) includes a protruding part (8) protruding toward a second thin line-shaped electrode (4A) adjacent to the first thin line-shaped electrode (4A) and provided in a connection region of the surface to which the wiring member (2) is connected; wherein the first thin line-shaped electrode (4A) includes a linear part perpendicular to the wiring member (2), the linear part being connected to the protruding part (8) and the protruding part (8) being connected to the wiring member (2),
   **characterized in that**:

   the solar cell module further comprises an auxiliary electrode (4C) provided in the connection region, wherein each of the plurality of thin line-shaped electrodes (4A) includes the protruding part (8),
   the auxiliary electrode (4C) connects each of the protruding part (8) of the plurality of thin line-shaped electrodes (4A), and
   a longitudinal direction of the auxiliary electrode (4C) corresponds to the arrangement direction (Y).

2. The solar cell module according to claim 1, wherein
   the wiring member (2) includes a core member (2a) and a conductive layer (2b), and the first thin line-shaped electrode (4A) comes into the conductive layer (2b), so that the wiring member (2) and the solar cell (3) are electrically connected to each other.

3. The solar cell module according to claim 1, wherein the auxiliary electrode (4C) comes into the conductive layer (2b), so that the wiring member and the solar cell (3) are electrically connected to each other.

4. The solar cell module according to claim 1, wherein the wiring member (2) and each solar cell (3) are mechanically connected to each other with a resin (7), and a periphery of the protruding part (8) is also covered with the resin.

5. The solar cell module according to claim 1, wherein the protruding part (8) is in the form of an arc.

6. The solar cell module according to claim 1, wherein the protruding part (8) is in the form of a trapezoid.

7. The solar cell module according to claim 1, wherein the top portion of the protruding part is discontinuous.


## Patentansprüche

1. Solarzellenmodul, umfassend:

   eine Vielzahl von Solarzellen (3), die entlang einer Anordnungsrichtung (Y) angeordnet sind; und
   ein Verdrahtungselement (2), das konfiguriert ist, die Vielzahl von Solarzellen (3) miteinander elektronisch zu verbinden,
   wobei jede aus der Vielzahl von Solarzellen (3) eine Oberfläche und eine Vielzahl von dünnen linienförmigen Elektroden (4A), die auf der Oberfläche entlang der Anordnungsrichtung (Y) angeordnet sind, umfasst,
   wobei das Verdrahtungselement (2) mit den dünnen linienförmigen Elektroden (4A) elektrisch verbunden ist, und
   wobei eine erste dünne linienförmige Elektrode (4A) aus der Vielzahl von dünnen linienförmigen Elektroden (4A) einen vorstehenden Teil (8) umfasst, der zu einer zweiten dünnen linienförmigen Elektrode (4A) hin vorsteht, die angrenzend an die erste dünne linienförmige Elektrode (4A) angeordnet und in einer Verbindungsregion der Oberfläche, mit der das Verdrahtungselement (2) verbunden ist, vorgesehen ist; wobei die erste dünne linienförmige Elektrode (4A) einen linearen Teil umfasst, der zum Verdrahtungselement (2) senkrecht ist, wobei der lineare Teil mit dem vorstehenden Teil (8) verbunden ist, und der vorstehende Teil (8) mit dem Verdrahtungselement (2) verbunden ist, **dadurch gekennzeichnet, dass**:

das Solarzellenmodul ferner eine Hilfselektrode (4C) umfasst, die in der Verbindungsregion vorgesehen ist, jede aus der Vielzahl von dünnen linienförmigen Elektroden (4A) den vorstehenden Teil (8) umfasst, die Hilfselektrode (4C) jeden des vorstehenden Teils (8) aus der Vielzahl von dünnen linienförmigen Elektroden (4A) verbindet, und wobei eine Längsrichtung der Hilfselektrode (4C) der Anordnungsrichtung (Y) entspricht.

2. Solarzellenmodul gemäß Anspruch 1, wobei das Verdrahtungselement (2) ein Kernelement (2a) und eine leitfähige Schicht (2b) umfasst, und wobei die erste dünne linienförmige Elektrode (4A) in die leitfähige Schicht (2b) hineinreicht, sodass das Verdrahtungselement (2) und die Solarzelle (3) elektrisch miteinander verbunden sind.

3. Solarzellenmodul gemäß Anspruch 1, wobei die Hilfselektrode (4C) in die leitfähige Schicht (2b) hineinreicht, sodass das Verdrahtungselement und die Solarzelle (3) elektrisch miteinander verbunden sind.

4. Solarzellenmodul gemäß Anspruch 1, wobei das Verdrahtungselement (2) und jede Solarzelle (3) mit einem Harz (7) mechanisch miteinander verbunden sind, und wobei ein Randbereich des vorstehenden Teils (8) ebenfalls mit dem Harz bedeckt ist.

5. Solarzellenmodul gemäß Anspruch 1, wobei der vorstehende Teil (8) in der Form eines Bogens ist.

6. Solarzellenmodul gemäß Anspruch 1, wobei der vorstehende Teil (8) in der Form eines Trapezes ist.

7. Solarzellenmodul gemäß Anspruch 1, wobei der Oberseitenabschnitt des vorstehenden Teils diskontinuierlich ist.

**Revendications**

1. Module de cellules solaires, comprenant :

une pluralité de cellules solaires (3) agencées le long d'une direction d'agencement (Y) ; et un élément de câblage (2) configuré pour connecter électroniquement la pluralité de cellules solaires (3) les unes aux autres, dans lequel chacune de la pluralité de cellules solaires (3) comprend une surface et une pluralité d'électrodes minces en forme de ligne (4A) qui sont agencées sur la surface le long de la direction d'agencement (Y), l'élément de câblage (2) est connecté électriquement aux électrodes minces en forme de ligne (4A) et une première électrode mince en forme de ligne (4A) de la pluralité d'électrodes minces en forme de ligne (4A) comprend une partie en saillie (8) faisant saillie vers une seconde électrode mince en forme de ligne (4A) adjacente à la première électrode mince en forme de ligne (4A) et placée dans une zone de connexion de la surface à laquelle l'élément de câblage (2) est connecté ; dans lequel la première électrode mince en forme de ligne (4A) comprend une partie linéaire perpendiculaire à l'élément de câblage (2), la partie linéaire étant connectée à la partie en saillie (8), et la partie en saillie (8) étant connectée à l'élément de câblage (2), **caractérisé en ce que** :

le module de cellules solaires comprend en outre une électrode auxiliaire (4C) prévue dans la zone de connexion, dans lequel chacune de la pluralité d'électrodes minces en forme de ligne (4A) comprend la partie en saillie (8), l'électrode auxiliaire (4C) connecte chacune des parties en saillie (8) de la pluralité d'électrodes minces en forme de ligne (4A), et

une direction longitudinale de l'électrode auxiliaire (4C) correspond à la direction d'agencement (Y).

2. Module de cellules solaires selon la revendication 1, dans lequel
l'élément de câblage (2) comprend un élément de coeur (2a) et une couche conductrice (2b), et
la première électrode en forme de ligne mince (4A) vient dans la couche conductrice (2b), de sorte l'élément de câblage (2) et la cellule solaire (3) sont connectés électriquement l'un à l'autre.

3. Module de cellules solaires selon la revendication 1, dans lequel l'électrode auxiliaire (4C) vient dans la couche conductrice (2b), de sorte que l'élément de câblage et la cellule solaire (3) sont connectés électriquement l'un à l'autre.

4. Module de cellules solaires selon la revendication 1, dans lequel l'élément de câblage et chaque cellule solaire (3) sont connectés mécaniquement les uns aux autres avec une résine (7), et
une périphérie de la partie en saillie (8) est également recouverte de la résine.

5. Module de cellules solaires selon la revendication 1, dans lequel la partie en saillie (8) se présente sous la forme d'un arc.

6. Module de cellules solaires selon la revendication 1, dans lequel la partie en saillie (8) se présente sous la forme d'un trapèze.

7. Module de cellules solaires selon la revendication 1, dans lequel la partie supérieure de la partie en saillie est discontinue.

# FIG. 1

EP 2 113 948 B1

## FIG. 2A

## FIG. 2B

FIG. 3

## FIG. 4A

## FIG. 4B

## FIG. 4C

EP 2 113 948 B1

FIG. 5B

FIG. 5A

## FIG. 6

FIG. 7A

FIG. 7B

FIG. 7C

FIG. 7D

FIG. 7E

FIG. 7F

FIG. 8C

EP 2 113 948 B1

FIG. 9B

FIG. 9A

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002359388 A
- JP 2005101519 A
- WO 2008023795 A
- US 5009243 A